# DEMANDE DE BREVET EUROPEEN

(11) **EP 0 881 873 A1**
(43) Date de publication de la demande: **02.12.1998**
(21) Numéro de dépôt: 98201748.5
(22) Date de dépôt: 26.05.1998
(51) Int. Cl.: H05K 9/00

(54) **Ecran de blindage électromagnétique et support de circuit équipé d'un tel écran**

(30) Priorité: 29.05.1997 FR 9706581
(71) Demandeur: Koninklijke Philips Electronics N.V., 5621 BA Eindhoven (NL)
(72) Inventeur: Venant, Sylvain, 75008 Paris (FR)
(74) Mandataire: Landousy, Christian

(57) **Abrégé**

L'invention concerne un écran de blindage électromagnétique pour carte de circuit imprimé ou tout autre support similaire de circuit électronique. Ce blindage comprend une ceinture (30) et un ou plusieurs compartiments distincts (31, 32, 33), coiffés chacun d'un couvercle dont la forme correspond à celle du compartiment associé, et les dimensions externes de chaque couvercle correspondent au moins aux dimensions internes dudit compartiment associé pour une fixation en force de chaque couvercle dans son compartiment associé.
Application : blindage de téléphones portables.

## Description

La présente invention concerne un écran de blindage électromagnétique comprenant une ceinture et au moins un couvercle prévu pour la coiffer, la ceinture et le couvercle étant réalisés au moins en partie en un matériau électriquement conducteur et formant un sous-ensemble prévu pour être appliqué contre le support du circuit à blinder. Un tel écran de blindage est prévu pour être mis en place contre une carte de circuit imprimé ou contre tout autre support similaire de circuit électronique, par exemple dans un appareil téléphonique portable.

Un exemple d'association d'une carte de circuit imprimé et d'un écran de blindage électromagnétique est décrit dans la demande de brevet européen EP-A-0594041. Selon la structure indiquée dans ce document et illustrée sur la figure 1, l'écran de blindage est constitué d'une ceinture 11 et d'un couvercle coiffant celle-ci, qui forment l'un avec l'autre un sous-ensemble prévu pour être appliqué contre la carte de circuit imprimé 12 (ou autre support du circuit à blinder). Ce sous-ensemble est réalisé au moins en partie en un matériau électriquement conducteur afin de réaliser, pour la protection du circuit, une sorte de cage de Faraday. La réalisation du blindage en deux pièces distinctes permet éventuellement d'avoir accès aux circuits protégés, par ouverture du couvercle.

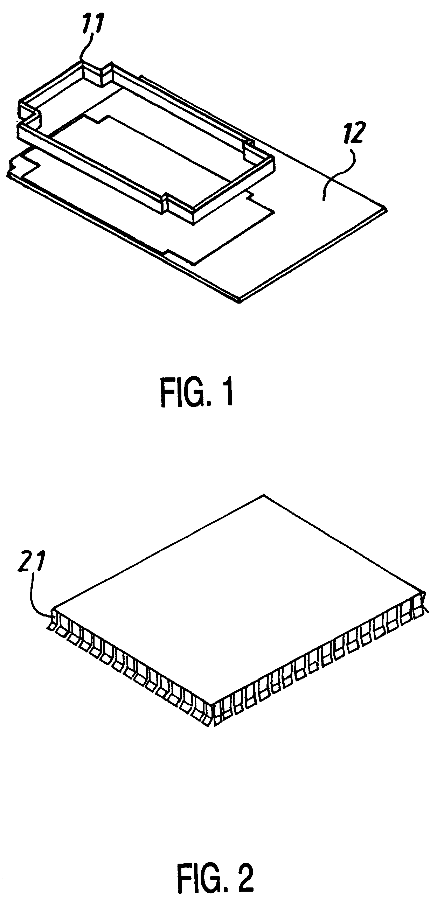

Les modes de liaison habituellement rencontrés pour la fixation du couvercle sur la ceinture sont la soudure, auquel cas la liaison est irréversible ou, du moins, implique des manipulations matérielles assez lourdes (dessouder/ressouder un couvercle), ou bien l'utilisation de solutions du genre lames ou rebords formant ressort et venant s'enclencher sur la ceinture. Ce genre de liaison, représenté par exemple sur la figure 2, est cette fois facilement démontable, mais les essais effectués montrent que des secousses ou des chocs exercés sur des structures ainsi réalisées conduisent souvent à l'ouverture intempestive du couvercle.

Un but de l'invention est donc de proposer un écran de blindage démontable dont la tenue aux chocs ou secousses soit bien meilleure que celle obtenue avec les réalisations antérieures.

A cet effet l'invention concerne un écran de blindage électromagnétique tel que défini dans le préambule de la description et qui est en outre caractérisé en ce que la fixation du couvercle sur la ceinture est assurée par le fait que la forme du couvercle correspond à celle de la ceinture et que les dimensions externes du couvercle correspondent au moins aux dimensions internes de la ceinture pour une fixation en force de l'un dans l'autre. Les essais effectués avec ce genre de structure confirment la fiabilité mécanique de la solution proposée.

Cette solution reste applicable même lorsque la ceinture de l'écran de blindage délimite plusieurs compartiments distincts. Dans ce cas, pour chacun des compartiments pour lesquels il est souhaitable de pouvoir accéder au circuit protégé par le blindage, la forme du couvercle correspond à celle du compartiment associé et ses dimensions externes correspondent au moins aux dimensions internes dudit compartiment associé pour une fixation en force de chaque couvercle dans son compartiment associé. Bien entendu, l'invention concerne l'une ou l'autre de ces structures d'écran de blindage, mais aussi toute carte de circuit imprimé ou tout autre support similaire de circuit électronique qui est équipé(e), pour la protection de ce circuit, d'une telle structure.

Les particularités et avantages de l'invention apparaîtront maintenant de façon plus détaillée dans la description qui suit et dans les dessins annexés, donnés à titre d'exemples et dans lesquels :
- la figure 1 montre un exemple de ceinture d'écran de blindage selon l'état de la technique, mise en place contre la carte ou le support du circuit à protéger ;
- la figure 2 illustre un exemple de couvercle d'écran de blindage selon l'état de la technique, dans lequel des pattes permettent la fixation du couvercle contre des rebords correspondants de la ceinture ou de compartiments de celles-ci ;
- la figure 3 met en évidence la structure et le mode de liaison qui permettent d'obtenir entre la ceinture et son ou ses couvercles, conformément à l'invention, une meilleure tenue aux chocs ou aux secousses.

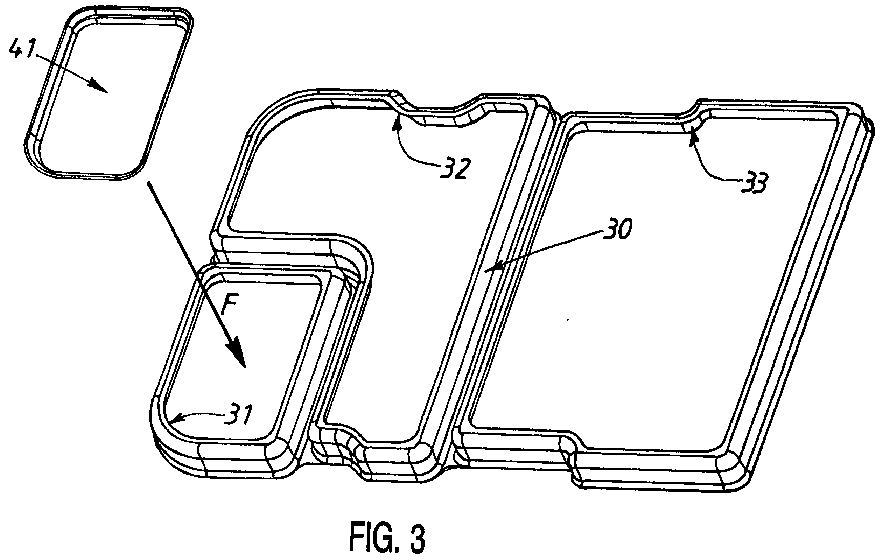

Conformément à l'invention, la structure maintenant proposée consiste, comme indiqué sur la figure 3, en une ceinture de blindage 30 ouverte à sa partie supérieure et, comprenant, dans l'exemple représenté, trois compartiments 31, 32, 33. Cette ceinture 30 est réalisée au moins en partie en un matériau conducteur (magnésium ou aluminium) coulé, acier plié ou embouti, alliage Zamak,...). Aux compartiments de la ceinture 30 sont associés des couvercles de forme correspondante, dont un seul, le couvercle 41 pour le compartiment 31, est représenté. Ces couvercles, amovibles pour permettre l'accès à la zone délimitée à l'intérieur de la ceinture 30, sont également réalisés au moins en partie en un matériau conducteur (acier plié ou embouti, matière plastique conductrice ou métallisée, carton formé ou plié et revêtu d'une couche métallique,...).

L'association de la ceinture et des couvercles (du couvercle lorsque la ceinture ne délimite qu'un seul et unique compartiment) constitue comme précédemment, pour la carte de circuit imprimé ou le support de circuit, une cage de Faraday, mais l'ouverture du ou d'un des couvercles de celle-ci est maintenant réalisable sans compromettre la tenue mécanique de l'ensemble ceinture/couvercle(s). En effet, chaque couvercle est délimité par un contour dont la forme correspond à celle du contour de la ceinture, et dont les dimensions externes sont juste déterminées, par rapport aux dimensions internes de ce contour correspondant de la ceinture, pour que le couvercle entre en force à l'intérieur de celle-ci et y soit très fermement immobilisé, quels que soient les chocs ou secousses auxquels pourrait ensuite être soumis l'ensemble ceinture/couvercle(s)/support du circuit.

## Revendications

1. Ecran de blindage électromagnétique pour carte de circuit imprimé ou tout autre support similaire de circuit électronique, comprenant une ceinture et au moins un couvercle prévu pour la coiffer, la ceinture et le couvercle étant réalisés au moins en partie en un matériau électriquement conducteur et formant un sous-ensemble prévu pour être appliqué contre le support du circuit à blinder, caractérisé en ce que la fixation du couvercle sur la ceinture est assurée par le fait que la forme du couvercle correspond à celle de la ceinture et que les dimensions externes du couvercle correspondent au moins aux dimensions internes de la ceinture pour une fixation en force de l'un dans l'autre.

2. Ecran de blindage selon la revendication 1, dans lequel la ceinture délimite plusieurs compartiments distincts, caractérisé en ce qu'un ou plusieurs compartiments sont coiffés chacun d'un couvercle dont la forme correspond à celle du compartiment associé et dont les dimensions externes correspondent au moins aux dimensions internes dudit compartiment associé pour une fixation en force de chaque couvercle dans son compartiment associé.

3. Ecran de blindage selon l'une des revendications 1 et 2, caractérisé en ce que la ceinture est réalisée en un matériau choisi dans la liste suivante : aluminium ou magnésium coulé, acier plié ou embouti, alliage zamak,..., et en ce que chaque couvercle est réalisé en un matériau choisi dans la liste suivante : acier plié ou embouti, matière plastique conductrice ou métallisée, carton formé ou plié et muni d'un couche métallique,...

4. Carte de circuit imprimé ou autre support similaire de circuit électronique, caractérisé(e) en ce qu'elle(il) est équipé(e), pour la protection dudit circuit, d'un écran de blindage électromagnétique selon l'une des revendications 1 à 3.
